# FASCICULE DE BREVET EUROPEEN

(11) **EP 4 718 097 B1**
(45) Date de publication et mention de la délivrance du brevet: **09.12.2026**
(21) Numéro de dépôt: 25204508.3
(22) Date de dépôt: 25.09.2025
(51) Int. Cl.: G01R 31/382, G01K 7/36, H01M 10/48

(54) **MESURE PHYSIQUE AU COEUR D'UN ACCUMULATEUR ÉLECTROCHIMIQUE**
PHYSIKALISCHE KERNMESSUNG EINES ELEKTROCHEMISCHEN AKKUMULATORS
PHYSICAL MEASUREMENT ON THE CORE OF AN ELECTROCHEMICAL ACCUMULATOR

(30) Priorité: 25.09.2024 FR 2410226
(43) Date de publication de la demande: 01.04.2026
(73) Titulaire: Commissariat à l'Energie Atomique et aux Energies Alternatives, 75015 Paris (FR)
(72) Inventeur: RANIERI, Marco, 38054 GRENOBLE CEDEX 9 (FR); CHAUVIN, Julien, 38054 GRENOBLE CEDEX 9 (FR); BRUN-BUISSON, David, 38054 GRENOBLE CEDEX 9 (FR); SERRA, Lionel, 38054 GRENOBLE CEDEX 9 (FR)
(74) Mandataire: Lavoix

(56) Documents cités:
- DE-A1- 10 258 845
- DE-A1- 102017 215 144
- US-A1- 2019 305 387

## Description

La présente invention concerne un système de mesure physique au coeur d'un accumulateur électrochimique présentant deux bornes de puissance distinctes.

La présente invention concerne également un procédé de mesure physique au coeur d'un accumulateur électrochimique présentant deux bornes de puissance distinctes.

L'invention se situe dans le domaine de la gestion de batteries et plus précisément celui des accumulateurs électrochimiques, tels que les accumulateurs électrochimiques Li-ion, les accumulateurs électrochimiques NiMH, les accumulateurs électrochimiques Pb, etc.

Plus précisément, la présente invention porte sur le contrôle d'au moins une grandeur physique interne d'un accumulateur électrochimique (i.e. également appelée cellule électrochimique), ladite grandeur physique interne correspondant par exemple à la température interne de l'accumulateur électrochimique considéré, à sa pression interne, à une déformation en surface, un étirement, l'état de charge, la concentration de ions Li+ (i.e. ions Lithium+), etc.

Actuellement, il existe déjà des solutions ayant pour objectif de collecter de l'information sur l'état interne d'une batterie correspondant à un ensemble d'accumulateurs électrochimiques, chaque accumulateur électrochimique présentant par nature deux bornes de puissances (i.e. électrodes) distinctes.

Par exemple, une première solution est basée sur la mesure de l'impédance interne de l'accumulateur électrochimique considéré, mais une telle mesure nécessite une mesure à quatre fils par accumulateur électrochimique ce qui est trop couteux à implémenter dans un pack de batterie comprenant une pluralité d'accumulateurs électrochimiques.

En effet, l'ajout de chacune des deux bornes de puissances (i.e. de électrodes) nécessaires pour faire une mesure à quatre fils, en sus des deux bornes de puissances (i.e. électrodes) propres à l'accumulateur électrochimique, est une source de coût supplémentaire, car cela nécessite non seulement du travail et/ou du développement pour garantir l'étanchéité de l'accumulateur électrochimique (i.e. la cellule électrochimique) autour de la borne de puissance (i.e. l'électrode) ajoutée, mais aussi le déploiement de connexions (i.e. fils) spécialement dédiées à la mesure entre la cellule et le système de gestion de batterie BMS (de l'anglais *Battery Management System).*

Une deuxième solution porte sur l'insertion de fibres optiques dans la partie active de chaque accumulateur électrochimique mais cette deuxième solution nécessite d'avoir un système d'optique couteux, un collimateur et un analyseur de spectre pour extraire de l'information utile. De plus, cette instrumentation est intrusive au niveau de l'architecture (i.e. de l'enveloppe) de l'accumulateur électrochimique, ce qui engendre des problèmes supplémentaires tels que la gestion des fuites et la gestion de la corrosion associée.

D'autres solutions sont dites de type « Cellule intelligente» (i.e. de l'anglais *smart cell*), à savoir basées sur l'introduction d'un microcontrôleur relativement puissant dans chaque accumulateur électrochimique (i.e. cellule électrochimique), et requérant l'établissement d'un canal de communication numérique entre l'accumulateur électrochimique considéré et l'extérieur, ce canal de communication étant filaire, capacitif, optique, par courant porteur, etc., ce qui est également complexe et onéreux à mettre en œuvre.

US2019/305387A1 divulgue un capteur de température arrangé à l'intérieur d'une batterie.

Le capteur de température comprend un condensateur et une inductance formant un circuit résonant. La température de la batterie est estimée à partir de la fréquence de résonance du circuit résonant.

Autrement dit, les solutions existantes sont peu réalistes d'un point de vue techno-économique.

Le but de l'invention est alors de proposer une solution permettant de minimiser impact et coûts du contrôle d'au moins une grandeur physique interne d'un accumulateur électrochimique.

A cet effet, l'invention a pour objet un système de mesure physique au cœur d'un accumulateur électrochimique présentant deux bornes de puissance distinctes, ledit système comprenant au moins :
- au moins un capteur inductif introduit à l'intérieur dudit accumulateur électrochimique, et connecté via une de ses extrémités à une desdites deux bornes de puissance distinctes, l'autre extrémité dudit capteur inductif étant connectée, via un élément électrique de blocage de courant continu, à l'autre desdites deux bornes de puissance distinctes ;
- un ensemble d'éléments électriques externes audit accumulateur électrochimique, ledit ensemble étant connecté via chacune de ses deux extrémités à chacune desdites deux bornes de puissance distinctes de sorte à former, avec ledit au moins un capteur inductif, au moins un circuit électrique résonant propre à résonner dans au moins une première plage de fréquence prédéterminée ;
- un module de mesure, externe audit accumulateur électrochimique, configuré pour :
   - exciter ledit au moins un circuit électrique résonant, via un balayage en fréquence en pilotant une génération de tension d'alimentation, au niveau desdites deux bornes de puissance distinctes, sur une deuxième plage de fréquence prédéterminée étendue, ladite deuxième plage de fréquence prédéterminée étendue comprenant ladite au moins une première plage de fréquence prédéterminée ;
   - mesurer au moins une fréquence de résonance résultant dudit balayage en fréquence d'excitation ;
   - obtenir une valeur d'au moins une grandeur physique interne dudit accumulateur électrochimique à partir de ladite au moins une fréquence de résonance mesurée.

Ainsi, la présente invention propose de définir un nouveau type de capteurs permettant une intégration aisée au sein des accumulateurs électrochimiques. L'intégration de ce type de capteur est propre à être appliquée dès la conception de l'accumulateur électrochimique ou ultérieurement.

Avantageusement, la présente invention évite d'ajouter une borne de puissance (i.e. électrode) à l'accumulateur électrochimique, à part les bornes de puissances (i.e. électrodes) positive et négative déjà présentes.

Ainsi, la présente invention permet, en insérant, au sein de l'accumulateur électrochimique, un outil de diagnostic tel que le capteur inductif proposé dont la valeur d'inductance varie en fonction de la grandeur physique interne à mesurer, de réaliser des contrôles non destructifs qui ne perturberont pas le bon fonctionnement électrochimique tout en ne modifiant pas l'agencement des bornes de puissances (i.e. électrodes) des éléments de batteries (i.e. accumulateurs électrochimiques) actuellement développés.

A noter que l'introduction d'un tel capteur inductif à l'intérieur de l'accumulateur électrochimique est nécessairement associée à l'introduction d'un élément électrique de blocage de courant continu (de l'anglais *DCstop*) pour ne pas laisser le courant continu et protéger les deux bornes de puissance dudit accumulateur électrochimique contre tout court-circuit. Un tel élément étant par exemple un condensateur ajouté en série avec ledit capteur inductif à l'intérieur dudit accumulateur électrochimique.

Ainsi la présente invention répond à la nécessité d'être au plus proche d'une réalisation à l'échelle industrielle.

Suivant d'autres aspects avantageux de l'invention, le système de mesure physique au coeur d'un accumulateur électrochimique comprend une ou plusieurs des caractéristiques suivantes, prises isolément ou suivant toutes les combinaisons techniquement possibles :
- ledit ensemble d'éléments électriques externes audit accumulateur électrochimique comprend au moins une résistance et au moins un condensateur de sorte à former en série avec ledit au moins un capteur inductif ledit au moins un circuit électrique résonant ;
- ledit au moins un capteur inductif et chaque élément électrique dudit ensemble d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique est maximale ;
- le système comprend en outre, à l'intérieur dudit accumulateur électrochimique, un ensemble d'éléments de filtrage limitant la perturbation due à l'impédance interne propre uniquement audit accumulateur électrochimique et/ou due à la présence d'au moins un équipement externe connecté audit accumulateur électrochimique ;
- ledit ensemble d'éléments de filtrage comprend quatre éléments inductifs insérés en série entre lesdites deux bornes de puissance distinctes dudit accumulateur électrochimique ;
- la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système ;
- ledit système comprend au moins deux capteurs inductifs distincts de sorte à former avec ledit ensemble d'éléments électriques externes audit accumulateur électrochimique au moins deux circuits électriques résonants distincts propres à résonner dans au moins deux premières plages de fréquence prédéterminées disjointes, ladite deuxième plage de fréquence prédéterminée étendue comprenant lesdites au moins deux premières plages de fréquence prédéterminées, les au moins deux fréquences de résonance résultantes mesurées associées auxdits au moins deux circuits électriques résonants distincts étant représentatives de deux grandeurs physiques internes distinctes dudit accumulateur électrochimique ;
- ledit au moins un capteur inductif est une inductance ;
- ledit au moins un capteur inductif est au moins un élément appartenant au groupe comprenant :
   - une jauge de déformation inductive ;
   - un diaphragme inductif ;
   - un capteur inductif à mouvement de noyau magnétique.
- ledit ensemble d'éléments électriques externes audit accumulateur électrochimique est déconnectable/reconnectable auxdites deux bornes de puissance distinctes

L'invention concerne également un procédé de mesure physique au coeur d'un accumulateur électrochimique présentant deux bornes de puissance distinctes, suivantes :
- introduction d'au moins un capteur inductif à l'intérieur dudit accumulateur électrochimique, ledit au moins un capteur inductif étant connecté via une de ses extrémités à une desdites deux bornes de puissance distinctes, l'autre extrémité dudit capteur inductif étant connectée, via un élément électrique de blocage de courant continu, à l'autre desdites deux bornes de puissance distinctes ;
- connexion d'un ensemble d'éléments électriques externes audit accumulateur électrochimique, via chacune de ses deux extrémités à chacune desdites deux bornes de puissance distinctes, de sorte à former, avec ledit au moins un capteur inductif, au moins un circuit électrique résonant propre à résonner dans au moins une première plage de fréquence prédéterminée ;
- excitation dudit au moins un circuit électrique résonant, via un balayage en fréquence en pilotant une génération de tension d'alimentation, au niveau desdites deux bornes de puissance distinctes, sur une deuxième plage de fréquence prédéterminée étendue, ladite deuxième plage de fréquence prédéterminée étendue comprenant ladite au moins une première plage de fréquence prédéterminée ;
- mesure d'au moins une fréquence de résonance résultant dudit balayage en fréquence d'excitation ;
- obtention d'une valeur d'au moins une grandeur physique interne dudit accumulateur électrochimique à partir de ladite au moins une fréquence de résonance mesurée

Suivant un autre aspect avantageux de l'invention, le procédé de mesure physique au cœur d'un accumulateur électrochimique comprend en outre l'introduction à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

L'invention apparaîtra plus clairement à la lecture de la description qui va suivre, donnée uniquement à titre d'exemple non limitatif, et faite en référence aux dessins dans lesquels :
[Fig. 1] la figure 1 est une représentation schématique d'un système de mesure physique au cœur d'un accumulateur électrochimique selon la présente invention.
[Fig. 2] la figure 2 est une représentation schématique d'un exemple de circuit équivalent au système de mesure physique au cœur d'un accumulateur électrochimique, selon la présente invention.
[Fig. 3] la figure 3 est un organigramme des principales étapes d'un procédé de mesure physique au cœur d'un accumulateur électrochimique selon la présente invention.

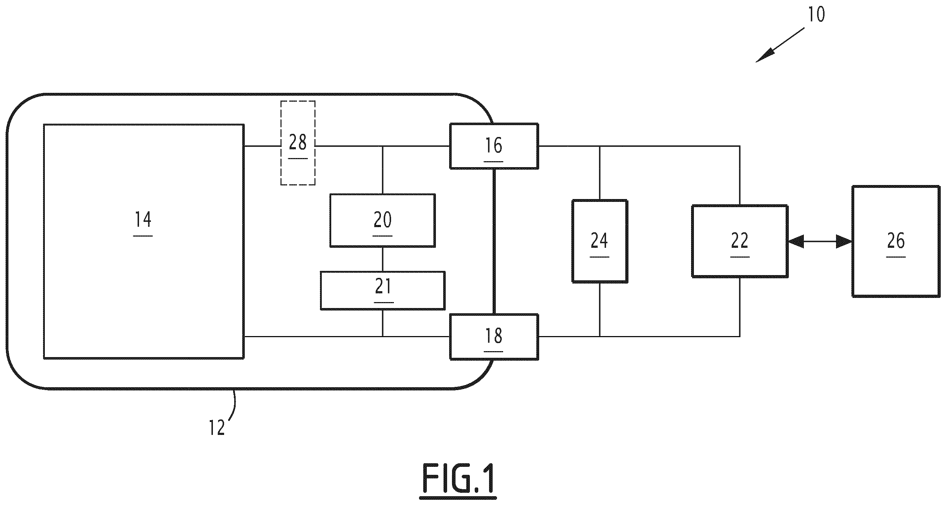

La figure 1 illustre un mode de réalisation d'un système 10 de mesure physique au cœur d'un accumulateur électrochimique 12. Sur la figure 1, ledit accumulateur électrochimique 12 comprend, en son enveloppe, une partie active 14 et présente deux bornes de puissance distinctes (i.e. deux électrodes distinctes) 16 et 18.

Selon la présente invention, le système 10 de mesure physique au cœur de l'accumulateur électrochimique 12 comprend en outre au moins un capteur inductif 20 propre à être mis en place (i.e. introduit) à l'intérieur dudit accumulateur électrochimique 12 (i.e. à l'intérieur de son enveloppe, de son boitier), notamment lors de la fabrication dudit accumulateur électrochimique 12, et connecté via une de ses extrémités à une desdites deux bornes de puissance distinctes, l'autre extrémité dudit capteur inductif étant connectée, via un élément 21 électrique de blocage de courant continu, à l'autre desdites deux bornes de puissance distinctes. Autrement dit, selon un exemple, on construit directement l'accumulateur électrochimique 12 avec le capteur inductif 20 à l'intérieur.

A noter que l'introduction d'un tel capteur inductif 20 à l'intérieur de l'accumulateur électrochimique est nécessairement associée à l'introduction de l'élément 21 électrique de blocage de courant continu (de l'anglais *DCstop*) pour ne pas laisser le courant continu et protéger les deux bornes de puissance dudit accumulateur électrochimique contre tout court-circuit. Un tel élément 21 étant par exemple un condensateur ajouté en série avec ledit capteur inductif 20 à l'intérieur dudit accumulateur électrochimique 12.

De plus, ledit système de mesure 10 comprend également un ensemble 22 d'éléments électriques externes audit accumulateur électrochimique 12 (i.e. en dehors de son enveloppe, c'est-à-dire de son boitier), ledit ensemble 22 étant connecté, en parallèle tel qu'illustré par la figure 1, via chacune de ses deux extrémités à chacune desdites deux bornes de puissance distinctes 16 et 18 de sorte à former, avec ledit au moins un capteur inductif 20, au moins un circuit électrique résonant propre à résonner dans au moins une première plage de fréquence prédéterminée.

Comme illustré également par la figure 1, classiquement, une charge 24 est placée également en parallèle desdites deux bornes de puissance distinctes 16 et 18.

Le système de mesure 10 comprend en outre, selon la présente invention, un module de mesure 26, externe audit accumulateur électrochimique. Un tel module de mesure 26 est tout d'abord propre à exciter ledit au moins un circuit électrique résonant, via un balayage en fréquence en pilotant une génération de tension d'alimentation, au niveau desdites deux bornes de puissance distinctes 16 et 18, sur une deuxième plage de fréquence prédéterminée étendue, ladite deuxième plage de fréquence prédéterminée étendue (i.e. plage de balayage en fréquence) comprenant ladite au moins une première plage de fréquence prédéterminée (i.e. plage de résonance).

De plus, le module de mesure 26 est également propre à mesurer au moins une fréquence de résonance produite par ledit au moins un circuit électrique résonant excité par ledit balayage en fréquence d'excitation.

Le module de mesure 26 est en outre propre à obtenir une valeur d'au moins une grandeur physique interne dudit accumulateur électrochimique 12 à partir de ladite au moins une fréquence de résonance mesurée. Autrement dit, l'information utile pour la mesure de la grandeur physique interne souhaitée s'étudie en fréquence, la fréquence de résonance mesurée étant représentative de la grandeur physique interne associée au sein de l'accumulateur électrochimique 12. Par exemple, une table déterminée au préalable permet d'associer la valeur de fréquence de résonance mesurée à une valeur de ladite grandeur physique interne.

Ainsi, le système de mesure 10, selon la présente invention, utilise la capacité d'auto-résonance du circuit électrique résonant formé d'une part par ledit au moins un capteur inductif 20 interne à l'accumulateur électrochimique 12 et d'autre part par un ensemble 22 d'éléments électriques externes audit accumulateur électrochimique 12.

Pour ce faire, ledit au moins un capteur inductif 20 implémenté, dudit au moins un circuit électrique résonant, est adressé (i.e. « interrogé ») en fréquence via ledit module de mesure 26 et non en courant continu, et est uniquement connecté entre les deux bornes de puissance 16 et 18 (i.e. électrodes de puissance), respectivement positive et négative, naturellement présentes pour connecter l'accumulateur électrochimique 12 (i.e. de la cellule électrochimique), ce qui évite toute borne de puissance additionnelle (i.e. d'électrode supplémentaire).

Ainsi, selon la présente invention, il est proposé d'utiliser un ou plusieurs capteurs inductif(s) à l'intérieur de l'accumulateur électrochimique (i.e. de la cellule électrochimique), dont l'information utile s'étudie en fréquence, et faisant partie d'un circuit resonnant dont le reste 22 des composants se trouve à l'extérieur de la cellule, même à une distance considérable, comme par exemple sur le circuit imprimé (i.e. la carte PCB (de l'anglais printed circuit board) du système de gestion de batterie BMS (de l'anglais *Battery Management System*) du module de la batterie. Ledit au moins un capteur inductif, en variant sa valeur « électronique », c'est-à-dire sa valeur d'inductance en fonction de la grandeur physique interne en jeu, notamment la température de son environnement, est ainsi propre à donner une information sur ce qui se passe à l'intérieur de l'accumulateur électrochimique (i.e. de la cellule électrochimique).

Le fait de pouvoir interroger à distance le capteur inductif 20, et sans connectiques additionnelles, constitue un avantage considérable du point de vue d'une possible industrialisation, car cela laisse libre le constructeur de choisir l'emplacement du circuit résonant (i.e. notamment de ces éléments externes) selon ce qui est le plus avantageux pour lui.

En complément facultatif, ledit ensemble 22 d'éléments électriques externes audit accumulateur électrochimique est déconnectable/reconnectable auxdites deux bornes de puissance distinctes 16 et 18. Autrement dit, selon ce complément facultatif, il est également envisageable de n'implémenter qu'un seul circuit résonant, dont la connexion aux différents éléments de la batterie, à savoir les différents accumulateurs électrochimiques de la batterie, est aiguillée par multiplexage.

En outre, il est à noter que la nature inductive du capteur 20 requiert d'ajouter un système de blocage du courant continu contre les court-cicruits propres à endommager les deux bornes de puissance 16 et 18 (i.e. électrodes) de de l'accumulateur électrochimique (i.e. de la cellule électrochimique).

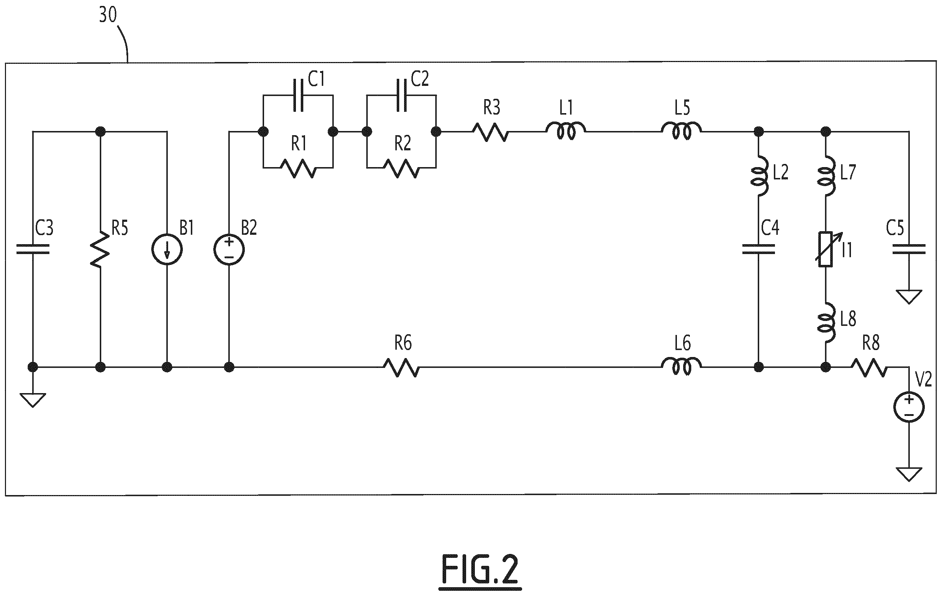

En complément facultatif, tel qu'illustré par la suite par la figure 2, ledit ensemble 22 d'éléments électriques externes audit accumulateur électrochimique 12 comprend au moins une résistance et au moins un condensateur de sorte à former en série avec ledit au moins un capteur inductif ledit au moins un circuit électrique résonant.

Selon une première variante, ledit au moins un capteur inductif 20 et chaque élément électrique dudit ensemble 22 d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique 12 est maximale.

Une telle première variante est intéressante, car si l'impédance résultante dudit accumulateur électrochimique 12 (i.e. l'impédance globale de l'accumulateur électrochimique après connexion aux éléments 20 et 22 de la présente invention) est élevée dans une plage de fréquences précises, et supérieure de plusieurs ordres de grandeurs par rapport à l'impédance interne propre uniquement audit accumulateur électrochimique 12 à régime continu, alors le signal du résonateur (i.e. du circuit résonant) est propre à être naturellement peu atténué par l'impédance interne propre uniquement audit accumulateur électrochimique 12 (i.e. l'impédance naturelle de la cellule électrochimique 12 sans connexion aux éléments 20 et 22 de la présente invention), et reste exploitable en permanence, sans nécessiter l'ajout d'éléments de filtrage dédiés à protéger, le signal utile du résonateur, de la perturbation due à l'impédance naturelle de l'accumulateur électrochimique lui-même et/ou due à l'éventuelle présence d'un équipement externe connecté à l'accumulateur électrochimique, tel qu'un moteur, un chargeur, etc...

A titre d'alternative à la première variante, selon une deuxième variante, tel qu'illustré en pointillés sur la figure 1 et représenté en détail sur la figure 2 décrite par la suite, le système 10 de mesure physique selon la présente invention, comprend en outre optionnellement, à l'intérieur dudit accumulateur électrochimique 12, un ensemble 28 d'éléments de filtrage limitant la perturbation due à l'impédance interne propre uniquement audit accumulateur électrochimique et/ou due à la présence d'au moins un équipement externe connecté audit accumulateur électrochimique 12.

En complément facultatif de cette deuxième variante, tel qu'illustré par la suite par la figure 2, ledit ensemble 28 d'éléments de filtrage comprend quatre éléments inductifs insérés en série entre lesdites deux bornes de puissance distinctes 16 et 18 dudit accumulateur électrochimique 12.

En option pour ce complément facultatif, la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système.

Selon un autre complément facultatif, ledit système 10 comprend au moins deux capteurs inductifs distincts de sorte à former avec ledit ensemble d'éléments électriques externes audit accumulateur électrochimique au moins deux circuits électriques résonants distincts propres à résonner dans au moins deux premières plages de fréquence prédéterminées disjointes, ladite deuxième plage de fréquence prédéterminée étendue comprenant lesdites au moins deux premières plages de fréquence prédéterminées, les au moins deux fréquences de résonance résultantes mesurées associées auxdits au moins deux circuits électriques résonants distincts étant représentatives de deux grandeurs physiques internes distinctes dudit accumulateur électrochimique.

En effet, sachant qu'un objet électronique peut présenter plusieurs fréquences de résonance, avec un choix astucieux de capteurs/composants, selon ce complément facultatif il est proposé d'introduire plusieurs capteurs inductifs différents à l'intérieur de l'accumulateur électrochimique, par exemple un qui fait varier la fréquence de résonance autour de 10 kHz et l'autre autour de 100 kHz, rendant possible le discernement de l'origine (i.e. de la grandeur physique interne) associée au signal mesuré et donc d'obtenir deux informations distinctes, tel que par exemple la température et l'état de charge dudit accumulateur électrochimique.

Selon un autre complément facultatif, ledit au moins un capteur inductif est une inductance.

Autrement dit, ce complément facultatif consiste à utiliser un capteur inductif sous forme simplifiée, correspondant à une inductance qui varie son inductance en fonction de la température. L'inductance simple, ou la combinaison de plusieurs inductances simples, est propre, lorsqu'elle rentre en résonance avec le reste des éléments externes de l'ensemble 22, à fournir une fréquence de résonance dont la valeur mesurée est associée à une valeur prédéterminée de température. Autrement dit, selon cet exemple où le capteur inductif est une simple inductance, la valeur de fréquence de résonance mesurée est représentative d'une valeur de température au sein de (i.e. au cœur de) l'accumulateur électrochimique considéré.

A titre d'alternative, selon un autre complément facultatif, ledit au moins un capteur inductif est au moins un élément (ou combinaison d'éléments) appartenant au groupe comprenant :
- une jauge de déformation inductive ;
- un diaphragme inductif ;
- un capteur inductif à mouvement de noyau magnétique ;
- etc.

La jauge de déformation inductive est quant à elle propre, lorsqu'elle rentre en résonance avec le reste des éléments externes de l'ensemble 22, à fournir une fréquence de résonance dont la valeur mesurée est associée à une valeur prédéterminée de déformation en surface, d'étirement au sein de (i.e. au cœur de) l'accumulateur électrochimique considéré.

Le diaphragme inductif ou le capteur inductif à mouvement de noyau magnétique sont quant à eux chacun propres, lorsqu'ils rentrent en résonance avec le reste des éléments externes de l'ensemble 22, à fournir une fréquence de résonance dont la valeur mesurée est associée à une valeur prédéterminée de pression au sein de (i.e. au cœur de) l'accumulateur électrochimique considéré.

La figure 2 est une représentation schématique d'un exemple de circuit équivalent 30 au système de mesure physique au cœur d'un accumulateur électrochimique, selon la présente invention.

En effet, pour valider l'approche selon la présente invention, des simulations ont été réalisées en utilisant un circuit équivalent.

Selon l'exemple de la figure 2, l'accumulateur électrochimique correspond notamment à une cellule Li-ion générique représentée par un circuit selon un « modèle RC » d'une batterie ayant une capacité de 3 à 5 Ampères-heure (i.e. 3,5 à 5Ah), composée par les éléments capacitifs : C1, C2, C3, résistifs : R1, R2, R3, R5, R6, inductifs : L1 et les générateurs de courant ou de tension B1, B2 et I1.

Par exemple, pour une cellule Li-ion générique d'une batterie ayant une capacité de 3 à 5 Ampères-heure, on considère les valeurs suivantes : C1=1000pF, C2=10µF C3=18000F, R1=0,1Ω, R2=0,1Ω, R3=0,1Ω, R5=10kΩ, R6=1mΩ, L1=1nH. En simulation, le comportement d'un circuit formé des seuls éléments précités a été simulé afin de vérifier que son comportement est cohérent notamment avec celui d'un accumulateur électrochimique de capacité d'environ 3,5Ah qui se décharge avec un ampère de courant constant. Il est à noter que les valeurs précitées sont indicatives et non restrictives, car utilisées en simulation sans forcément avoir de contrepartie physique directe.

Selon la présente invention, le circuit équivalent 30 comprend en outre spécifiquement les éléments du systèmes de mesure physique proposé à savoir ledit au moins capteur inductif introduit à l'intérieur dudit accumulateur électrochimique et représentés sur l'exemple de la figure 2 par l'inductance L2, dont la valeur est par exemple propre à varier en fonction de la température interne audit accumulateur électrochimique entre 0,5mH et 20mH, ladite inductance L2 étant par ailleurs connectée à l'élément électrique de blocage de courant continu représenté par le condensateur C4 par exemple de valeur égale à 10µF, et l'ensemble d'éléments électriques (i.e. de composants) externes audit accumulateur électrochimique correspondant représentés sur l'exemple de la figure 2 par la résistance R8, telle que par exemple R8=4Ω, et le condensateur C5, telle que par exemple C5=10nF. A noter que selon cet exemple de dimensionnement où le condensateur C4 (10µF) présente au moins un ordre de grandeur plus grand que le condensateur C5 (10nF), le condensateur C4 n'intervient pas dans l'oscillation de résonance.

Avec ladite inductance L2 à l'intérieur de l'accumulateur électrochimique, les composants R8 et C5 externes audit accumulateur électrochimique forment, une fois connectés aux bornes de puissances dudit accumulateur électrochimique, le circuit résonateur dont la fréquence de résonance est représentative de la grandeur physique interne à mesurer au coeur de l'accumulateur électrochimique, telle que la température selon cet exemple.

A noter que la similation d'un circuit RLC formé uniquement des éléments L2, R8, et C5 avec ladite inductance L2 variant entre 0,5mH et 20mH, présente une fréquence de résonance ${f}_{0} = \frac{1}{2 π \sqrt{LC}}$ comprise respectivement entre 11,254 KHz et 71,18 KHz, ces valeurs étant représentatives de ce qu'on pourrait attendre un utilisant une inductance soumise à une variation de température comparable à ce qui peut se passer au coeur d'une cellule Li-ion, et permettant d'obtenir la référence d'un comportement idéal de résonateur.

L'exemple de la figure 2 correspond en particulier à la deuxième variante précédemment citée où le système de mesure physique selon la présente invention, comprend en outre optionnellement, à l'intérieur dudit accumulateur électrochimique, un ensemble d'éléments de filtrage limitant la perturbation due à l'impédance interne propre uniquement audit accumulateur électrochimique et/ou due à la présence d'au moins un équipement externe connecté audit accumulateur électrochimique. Cet ensemble d'éléments de filtrage, référencé 28 dans la figure 1, correspond dans le circuit équivalent 30 de la figure 2 aux inductances L5, L6, L7 et L8 en série avec les bornes de puissances distinctes de l'accumulateur électrochimique et vise à s'affranchir d'une perturbation qui se rapproche d'un courant continu. Selon l'exemple de la figure 2, la valeur de ces quatre inductances est par exemple de 100mH.

A noter que les inductances L5, L6, L7 et L8 ajoutées à titre de protection pour ne pas subir les perturbations dues à l'impédance propre de l'accumulateur électrochimique et/ou dues à ce qui y est connecté à l'extérieur requiert un dimensionnement selon lequel la valeur de chacun desdits éléments de filtrage inductifs L5, L6, L7 et L8 est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système de mesure selon la présente invention (i.e. sans les éléments C4, C5, R8, L2, L5, L6, L7, L8 et V2).

A noter que la définition de « dynamique initiale » dépend de l'application. Par exemple, une accélération brutale d'un véhicule électrique demande un courant important en quelques dizaines de millisecondes, alors qu'une recharge de batterie ne demande que des profils lents.

Un tel dimensionnement revient, en pratique, à chercher un temps de montée du courant dans l'accumulateur électrochimique au maximum dix fois supérieur au temps initial lorsque que ledit accumulateur électrochimique est déconnecté dudit système de mesure selon la présente invention (i.e. sans les éléments C4, C5, R8, L2, L5, L6, L7, L8 et V2), en considérant qu'on entend par « temps initial » le temps que le courant aurait mis à s'instaurer en l'absence des éléments L2, C5 et R8.

Autrement dit, le bon dimensionnement de l'ensemble des éléments de filtrage L5, L6, L7 et L8 est défini en se plaçant d'un point de vue « dynamique » de l'accumulateur électrochimique face à un appel de courant, afin de prendre en compte le besoin de ne pas dégrader les spécifications électriques de l'accumulateur électrochimique (i.e. de la cellule électrochimique), à savoir laisser passer le courant qui rentre ou qui sort de l'accumulateur électrochimique par le circuit de puissance.

En simulation, le comportement du circuit équivalent de la figure 2 a été comparé à celui du résonateur formé uniquement des éléments C5, R8, et L2, et il a été observé qu'il n'y a pas de différence substantielle et que la position en fréquence du pic de résonance est représentative de la valeur du capteur L2 placé à l'intérieur de la cellule, avec un décalage acceptable (i.e. dont la valeur est inférieure à un seuil prédéterminé) vers les hautes fréquences. Plus précisément, un tel décalage acceptable vers les hautes fréquences signifie que l'impédance de l'accumulateur électrochimique correspondant à une cellule Li-ion générique, correctement isolée par les composants spécifiquement dédiés à cette fonction, influence de manière négligeable la réponse fréquentielle du capteur inductif L2, et la faisabilité d'introduire un capteur «inductif » à l'intérieur de l'accumulateur électrochimique et de l'interroger en passant uniquement par ses bornes de puissance naturellement présentes.

Au vu de ce comportement, il est spécifiquement proposé selon la présente invention, via le module de mesure 26 de la figure 1 d'interroger ce capteur inductif L2 avec un balayage en fréquence, en pilotant le générateur de tension V2 du circuit équivalent de la figure 2 sur une plage de fréquence bien définie, à savoir une deuxième plage de fréquence prédéterminée étendue comprenant ladite au moins une première plage de fréquence prédéterminée dans laquelle le circuit formé des éléments C5, R8, et L2 est propre à résonner. Avantageusement, la position du pic de résonance est, selon la présente invention, un indicateur de la température selon l'exemple de la figure 2 (ou de la grandeur physique interne en général pour d'autres types de capteur inductif tels que cités précédemment) dont la mesure est requise (i.e. souhaitée).

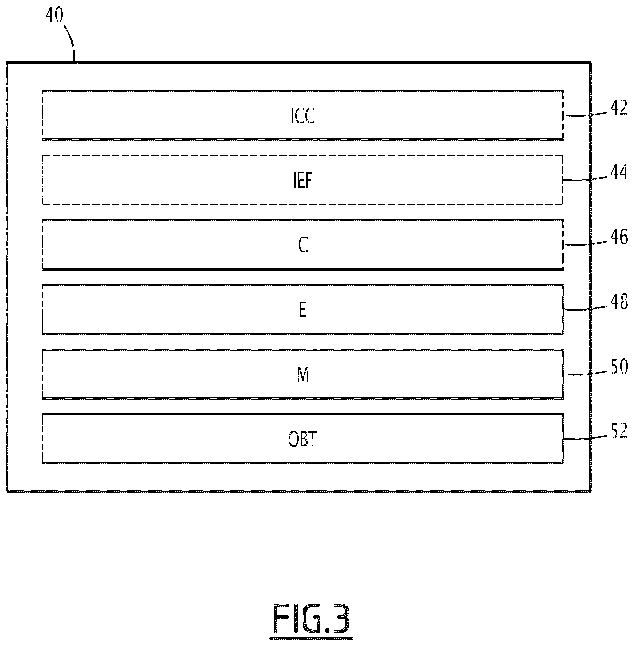

On décrit désormais ci-après, en relation avec la figure 3, un exemple de fonctionnement dudit système 10 de mesure physique.

Plus précisément, selon le mode de réalisation de la présente invention illustré par la figure 3, le procédé 40 de mesure physique au cœur d'un accumulateur électrochimique présentant deux bornes de puissance distinctes comprend une première étape 42 d'introduction ICC d'au moins un capteur inductif à l'intérieur dudit accumulateur électrochimique, ledit au moins un capteur inductif étant connecté via une de ses extrémités à une desdites deux bornes de puissance distinctes, l'autre extrémité dudit capteur inductif étant connectée, via un élément électrique de blocage de courant continu, à l'autre desdites deux bornes de puissance distinctes.

Optionnellement, tel que représenté en pointillés, notamment lorsque la deuxième variante précitée est mise en œuvre, le procédé 40 selon la présente invention comprend en outre une étape 44 d'introduction IEF à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

A noter que cette étape optionnelle 44 n'est pas mise en œuvre (i.e. n'a pas besoin d'être mise en œuvre) lorsque, tel que décrit précédemment, selon une première variante, ledit au moins un capteur inductif et chaque élément électrique dudit ensemble d'éléments électriques externes formant, avec ledit au moins un capteur inductif, au moins un circuit électrique résonant, présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique est maximale.

Avec ou sans l'option 44 précitée, le procédé 40 selon la présente invention comprend également une étape 46 de connexion C dudit ensemble d'éléments électriques externes audit accumulateur électrochimique, via chacune de ses deux extrémités à chacune desdites deux bornes de puissance distinctes, de sorte à former, avec ledit au moins un capteur inductif, au moins un circuit électrique résonant propre à résonner dans au moins une première plage de fréquence prédéterminée.

Le procédé 40 selon la présente invention comprend en outre une étape 48 d'excitation E dudit au moins un circuit électrique résonant, via un balayage en fréquence en pilotant une génération de tension d'alimentation, au niveau desdites deux bornes de puissance distinctes, sur une deuxième plage de fréquence prédéterminée étendue, ladite deuxième plage de fréquence prédéterminée étendue comprenant ladite au moins une première plage de fréquence prédéterminée.

Le procédé 40 selon la présente invention comprend également une étape 50 de mesure M d'au moins une fréquence de résonance résultant dudit balayage en fréquence d'excitation.

Le procédé 40 selon la présente invention comprend enfin une étape 52 d'obtention OBT d'une valeur d'au moins une grandeur physique interne dudit accumulateur électrochimique à partir de ladite au moins une fréquence de résonance mesurée.

L'homme du métier comprendra que l'invention ne se limite pas aux modes de réalisation décrits, ni aux exemples particulier de la description, les modes de réalisation et les variantes mentionnées ci-dessus étant propres à être combinés entre eux pour générer de nouveaux modes de réalisation de l'invention.

La présente invention, permet ainsi de fournir une mesure physique du coeur (i.e. de l'intérieur) d'un accumulateur électrochimique, via l'interrogation par balayage fréquentiel sur une plage précise et significative de fréquences, dans laquelle l'information recherchée, à savoir la fréquence de résonance d'un résonateur RLC, formé par ledit au moins un capteur inductif et un ensemble d'éléments électriques externes audit accumulateur électrochimique, est contenue, et permet avantageusement d'éviter l'ajout de borne(s) de puissance supplémentaire(s) dédiée(s) à la mesure et le coût associé.

Le fait de pouvoir interroger à distance ledit au moins un capteur inductif, et sans connectiques additionnelles, constitue un avantage considérable du point de vue d'une possible industrialisation, car cela laisse libre le constructeur de choisir l'emplacement du circuit résonant selon ce qui est le plus avantageux pour lui.

## Revendications

1. Système (10) de mesure physique au coeur d'un accumulateur électrochimique (12) présentant deux bornes de puissance distinctes (16,18), **caractérisé en ce que** ledit système comprend au moins :
- au moins un capteur inductif (20) introduit à l'intérieur dudit accumulateur électrochimique, et connecté via une de ses extrémités à une desdites deux bornes de puissance distinctes, l'autre extrémité dudit capteur inductif étant connectée, via un élément (21) électrique de blocage de courant continu, à l'autre desdites deux bornes de puissance distinctes ;
- un ensemble (22) d'éléments électriques externes audit accumulateur électrochimique, ledit ensemble étant connecté via chacune de ses deux extrémités à chacune desdites deux bornes de puissance distinctes de sorte à former, avec ledit au moins un capteur inductif, au moins un circuit électrique résonant propre à résonner dans au moins une première plage de fréquence prédéterminée ;
- un module de mesure (26), externe audit accumulateur électrochimique, configuré pour :
- exciter ledit au moins un circuit électrique résonant, via un balayage en fréquence en pilotant une génération de tension d'alimentation, au niveau desdites deux bornes de puissance distinctes, sur une deuxième plage de fréquence prédéterminée étendue, ladite deuxième plage de fréquence prédéterminée étendue comprenant ladite au moins une première plage de fréquence prédéterminée ;
- mesurer au moins une fréquence de résonance résultant dudit balayage en fréquence d'excitation ;
- obtenir une valeur d'au moins une grandeur physique interne dudit accumulateur électrochimique à partir de ladite au moins une fréquence de résonance mesurée.

2. Système (10) de mesure physique selon la revendication 1, dans lequel ledit ensemble (22) d'éléments électriques externes audit accumulateur électrochimique (12) comprend au moins une résistance et au moins un condensateur de sorte à former en série avec ledit au moins un capteur inductif ledit au moins un circuit électrique résonant.

3. Système (10) de mesure physique selon la revendication 1 ou 2, dans lequel ledit au moins un capteur inductif (20) et chaque élément électrique dudit ensemble (22) d'éléments électriques présentent des valeurs préalablement déterminées de sorte que la fréquence de résonance dudit au moins un circuit électrique résonant résultant appartient à une troisième plage de fréquence dans laquelle l'impédance interne propre uniquement audit accumulateur électrochimique (12) est maximale.

4. Système (10) de mesure physique selon la revendication 1 ou 2, comprenant en outre, à l'intérieur dudit accumulateur électrochimique (12), un ensemble (28) d'éléments de filtrage limitant la perturbation due à l'impédance interne propre uniquement audit accumulateur électrochimique et/ou due à la présence d'au moins un équipement externe connecté audit accumulateur électrochimique.

5. Système (10) de mesure physique selon la revendication 4, dans lequel ledit ensemble (28) d'éléments de filtrage comprend quatre éléments inductifs insérés en série entre lesdites deux bornes de puissance distinctes dudit accumulateur électrochimique (10).

6. Système (10) de mesure physique selon la revendication 5, dans lequel la valeur de chacun desdits éléments de filtrage inductifs est définie telle que la dynamique correspondant au rapport de ladite valeur sur ladite impédance interne propre uniquement audit accumulateur électrochimique soit dix fois inférieure à la dynamique initiale dudit accumulateur électrochimique déconnecté dudit système.

7. Système (10) de mesure physique selon l'une quelconque des revendications précédentes, dans lequel ledit système comprend au moins deux capteurs inductifs distincts de sorte à former avec ledit ensemble d'éléments électriques externes audit accumulateur électrochimique au moins deux circuits électriques résonants distincts propres à résonner dans au moins deux premières plages de fréquence prédéterminées disjointes, ladite deuxième plage de fréquence prédéterminée étendue comprenant lesdites au moins deux premières plages de fréquence prédéterminées, les au moins deux fréquences de résonance résultantes mesurées associées auxdits au moins deux circuits électriques résonants distincts étant représentatives de deux grandeurs physiques internes distinctes dudit accumulateur électrochimique.

8. Système (10) de mesure physique selon l'une quelconque des revendications précédentes, dans lequel ledit au moins un capteur inductif est une inductance.

9. Système (10) de mesure physique selon l'une quelconque des revendications précédentes 1 à 7, dans lequel ledit au moins un capteur inductif est au moins un élément appartenant au groupe comprenant :
- une jauge de déformation inductive ;
- un diaphragme inductif ;
- un capteur inductif à mouvement de noyau magnétique.

10. Système (10) de mesure physique selon l'une quelconque des revendications précédentes, dans lequel ledit ensemble d'éléments électriques externes audit accumulateur électrochimique est déconnectable/reconnectable auxdites deux bornes de puissance distinctes.

11. Procédé (40) de mesure physique au coeur d'un accumulateur électrochimique présentant deux bornes de puissance distinctes, comprenant au moins les étapes suivantes :
- introduction (42) d'au moins un capteur inductif à l'intérieur dudit accumulateur électrochimique, ledit au moins un capteur inductif étant connecté via une de ses extrémités à une desdites deux bornes de puissance distinctes, l'autre extrémité dudit capteur inductif étant connectée, via un élément électrique de blocage de courant continu, à l'autre desdites deux bornes de puissance distinctes ;
- connexion (46) d'un ensemble d'éléments électriques externes audit accumulateur électrochimique, via chacune de ses deux extrémités à chacune desdites deux bornes de puissance distinctes, de sorte à former, avec ledit au moins un capteur inductif, au moins un circuit électrique résonant propre à résonner dans au moins une première plage de fréquence prédéterminée ;
- excitation (48) dudit au moins un circuit électrique résonant, via un balayage en fréquence en pilotant une génération de tension d'alimentation, au niveau desdites deux bornes de puissance distinctes, sur une deuxième plage de fréquence prédéterminée étendue, ladite deuxième plage de fréquence prédéterminée étendue comprenant ladite au moins une première plage de fréquence prédéterminée ;
- mesure (50) d'au moins une fréquence de résonance résultant dudit balayage en fréquence d'excitation ;
- obtention (52) d'une valeur d'au moins une grandeur physique interne dudit accumulateur électrochimique à partir de ladite au moins une fréquence de résonance mesurée.

12. Procédé (40) de mesure physique selon la revendication 11, comprenant en outre l'introduction (44) à l'intérieur dudit accumulateur électrochimique, d'un ensemble d'éléments de filtrage limitant la perturbation due à l'impédance interne propre uniquement audit accumulateur électrochimique et/ou due à la présence d'au moins un équipement externe connecté audit accumulateur électrochimique.

## Patentansprüche

1. Physikalisches Messsystem (10) im Inneren eines elektrochemischen Akkumulators (12), der zwei voneinander verschiedene Leistungsanschlüsse (16,18) aufweist, **dadurch gekennzeichnet, dass** das System mindestens umfasst:
- mindestens einen induktiven Sensor (20), der in das Innere des elektrochemischen Akkumulators eingeführt und über eines seiner Enden mit einem der zwei voneinander verschiedenen Leistungsanschlüsse verbunden ist, wobei das andere Ende des induktiven Sensors über ein elektrisches Bauelement (21) zur Gleichstromsperrung mit dem anderen der zwei voneinander verschiedenen Leistungsanschlüsse verbunden ist;
- eine Anordnung (22) von elektrischen Bauelementen außerhalb des elektrochemischen Akkumulators, wobei die Anordnung über jedes ihrer beiden Enden mit jeweils einem der zwei voneinander verschiedenen Leistungsanschlüsse verbunden ist, um mit dem mindestens einen induktiven Sensor mindestens eine resonante elektrische Schaltung zu bilden, die dazu geeignet ist, in mindestens einem ersten vorbestimmten Frequenzbereich in Resonanz zu treten;
- ein Messmodul (26) außerhalb des elektrochemischen Akkumulators, das konfiguriert ist, um :
- die mindestens eine resonante elektrische Schaltung über einen Frequenzdurchlauf durch Ansteuern einer Erzeugung einer Versorgungsspannung an den zwei voneinander verschiedenen Leistungsanschlüssen über einen zweiten erweiterten vorbestimmten Frequenzbereich anzuregen, wobei der zweite erweiterte vorbestimmte Frequenzbereich den mindestens einen ersten vorbestimmten Frequenzbereich umfasst;
- mindestens eine Resonanzfrequenz zu messen, die aus dem Anregungsfrequenzdurchlauf resultiert .
- einen Wert mindestens einer internen physikalischen Größe des elektrochemischen Akkumulators aus der mindestens einen gemessenen Resonanzfrequenz zu erhalten.

2. Physikalisches Messsystem (10) nach Anspruch 1, wobei die Anordnung (22) von elektrischen Bauelementen außerhalb des elektrochemischen Akkumulators (12) mindestens einen Widerstand und mindestens einen Kondensator umfasst, um in Reihe mit dem mindestens einen induktiven Sensor die mindestens eine resonante elektrische Schaltung zu bilden.

3. Physikalisches Messsystem (10) nach Anspruch 1 oder2, wobei der mindestens eine induktive Sensor (20) und jedes elektrische Bauelement der Anordnung (22) von elektrischen Bauelementen zuvor bestimmte Werte aufweisen, sodass die Resonanzfrequenz der resultierenden mindestens einen resonanten elektrischen Schaltung in einen dritten Frequenzbereich fällt, in dem die ausschließlich dem elektrochemischen Akkumulator (12) eigene interne Impedanz maximal ist.

4. Physikalisches Messsystem (10) nach Anspruch 1 oder 2, ferner umfassend, im Inneren des elektrochemischen Akkumulators (12), eine Anordnung (28) von Filterelementen, die die Störung begrenzen, die auf die ausschließlich dem elektrochemischen Akkumulator eigene interne Impedanz und/oder auf das Vorhandensein mindestens einer mit dem elektrochemischen Akkumulator verbundenen externen Ausrüstung zurückzuführen ist.

5. Physikalisches Messsystem (10) nach Anspruch 4, wobei die Anordnung (28) von Filterelementen vier induktive Elemente umfasst, die zwischen den zwei voneinander verschiedenen Leistungsanschlüssen des elektrochemischen Akkumulators (10) in Reihe eingefügt sind.

6. Physikalisches Messsystem (10) nach Anspruch 5, wobei der Wert jedes der induktiven Filterelemente derart definiert ist, dass die Dynamik, die dem Verhältnis des Werts zu der ausschließlich dem elektrochemischen Akkumulator eigenen internen Impedanz entspricht, zehnmal geringer als die anfängliche Dynamik des von dem System getrennten elektrochemischen Akkumulators ist.

7. Physikalisches Messsystem (10) nach einem der vorhergehenden Ansprüche, wobei das System mindestens zwei voneinander verschiedene induktive Sensoren umfasst, um mit der Anordnung von elektrischen Bauelementen außerhalb des elektrochemischen Akkumulators mindestens zwei voneinander verschiedene resonante elektrische Schaltungen zu bilden, die dazu geeignet sind, in mindestens zwei disjunkten ersten vorbestimmten Frequenzbereichen in Resonanz zu treten, wobei der zweite erweiterte vorbestimmte Frequenzbereich die mindestens zwei ersten vorbestimmten Frequenzbereiche umfasst und die mindestens zwei gemessenen resultierenden Resonanzfrequenzen, die den mindestens zwei voneinander verschiedenen resonanten elektrischen Schaltungen zugeordnet sind, für zwei voneinander verschiedene interne physikalische Größen des elektrochemischen Akkumulators repräsentativ sind.

8. Physikalisches Messsystem (10) nach einem der vorhergehenden Ansprüche, wobei der mindestens eine induktive Sensor eine Induktivität ist.

9. Physikalisches Messsystem (10) nach einem der vorhergehenden Ansprüche 1 bis 7, wobei der mindestens eine induktive Sensor mindestens ein Element ist, das zu der Gruppe gehört, die umfasst:
- einen induktiven Dehnungsmessstreifen;
- eine induktive Membran ;
- einen induktiven Sensor mit beweglichem Magnetkern.

10. Physikalisches Messsystem (10) nach einem der vorhergehenden Ansprüche, wobei die Anordnung von elektrischen Bauelementen außerhalb des elektrochemischen Akkumulators von den zwei voneinander verschiedenen Leistungsanschlüssen trennbar/wieder mit ihnen verbindbar ist.

11. Verfahren (40) zur physikalischen Messung im Inneren eines elektrochemischen Akkumulators, der zwei voneinander verschiedene Leistungsanschlüsse aufweist, mindestens die folgenden Schritte umfassend:
- Einführen (42) mindestens eines induktiven Sensors in das Innere des elektrochemischen Akkumulators, wobei der mindestens eine induktive Sensor über eines seiner Enden mit einem der zwei voneinander verschiedenen Leistungsanschlüsse verbunden ist und das andere Ende des induktiven Sensors über ein elektrisches Bauelement zur Gleichstromsperrung mit dem anderen der zwei voneinander verschiedenen Leistungsanschlüsse verbunden ist;
- Verbinden (46) einer Anordnung von elektrischen Bauelementen außerhalb des elektrochemischen Akkumulators über jedes ihrer beiden Enden mit jeweils einem der zwei voneinander verschiedenen Leistungsanschlüsse, um mit dem mindestens einen induktiven Sensor mindestens eine resonante elektrische Schaltung zu bilden, die dazu geeignet ist, in mindestens einem ersten vorbestimmten Frequenzbereich in Resonanz zu treten;
- Anregen (48) der mindestens einen resonanten elektrischen Schaltung über einen Frequenzdurchlauf durch Ansteuern einer Erzeugung einer Versorgungsspannung an den zwei voneinander verschiedenen Leistungsanschlüssen über einen zweiten erweiterten vorbestimmten Frequenzbereich, wobei der zweite erweiterte vorbestimmte Frequenzbereich den mindestens einen ersten vorbestimmten Frequenzbereich umfasst;
- Messen (50) mindestens einer Resonanzfrequenz, die aus dem Anregungsfrequenzdurchlauf resultiert;
- Erhalten (52) eines Werts mindestens einer internen physikalischen Größe des elektrochemischen Akkumulators aus der mindestens einen gemessenen Resonanzfrequenz.

12. Verfahren (40) zur physikalischen Messung nach Anspruch 11, ferner umfassend das Einführen (44) einer Anordnung von Filterelementen in das Innere des elektrochemischen Akkumulators, die die Störung begrenzen, die auf die ausschließlich dem elektrochemischen Akkumulator eigene interne Impedanz und/oder auf das Vorhandensein mindestens einer mit dem elektrochemischen Akkumulator verbundenen externen Ausrüstung zurückzuführen ist.

## Claims

1. Physical measurement system (10) at the core of an electrochemical accumulator (12) having two separate power terminals (16,18), **characterized in that** said system comprises at least:
- at least one inductive sensor (20) introduced inside said electrochemical accumulator, and connected via one of its ends to one of said two separate power terminals, the other end of said inductive sensor being connected, via a direct-current blocking electrical element (21), to the other of said two separate power terminals;
- an assembly (22) of electrical elements external to said electrochemical accumulator, said assembly being connected via each of its two ends to each of said two separate power terminals so as to form, with said at least one inductive sensor, at least one resonant electrical circuit capable of resonating within at least one first predetermined frequency range;
- a measurement module (26), external to said electrochemical accumulator, configured to :
- excite said at least one resonant electrical circuit, via a frequency sweep by controlling the generation of a supply voltage, at said two separate power terminals, over an extended second predetermined frequency range, said extended second predetermined frequency range comprising said at least one first predetermined frequency range;
- measure at least one resonance frequency resulting from said excitation frequency sweep .
- obtain a value of at least one internal physical quantity of said electrochemical accumulator from said at least one measured resonance frequency.

2. Physical measurement system (10) according to claim 1, wherein said assembly (22) of electrical elements external to said electrochemical accumulator (12) comprises at least one resistor and at least one capacitor so as to form, in series with said at least one inductive sensor, said at least one resonant electrical circuit.

3. Physical measurement system (10) according to claim 1 or 2, wherein said at least one inductive sensor (20) and each electrical element of said assembly (22) of electrical elements have previously determined values such that the resonance frequency of said at least one resulting resonant electrical circuit falls within a third frequency range in which the internal impedance specific solely to said electrochemical accumulator (12) is maximum.

4. Physical measurement system (10) according to claim 1 or 2, further comprising, inside said electrochemical accumulator (12), an assembly (28) of filtering elements limiting the disturbance due to the internal impedance specific solely to said electrochemical accumulator and/or due to the presence of at least one external piece of equipment connected to said electrochemical accumulator.

5. Physical measurement system (10) according to claim 4, wherein said assembly (28) of filtering elements comprises four inductive elements inserted in series between said two separate power terminals of said electrochemical accumulator (10).

6. Physical measurement system (10) according to claim 5, wherein the value of each of said inductive filtering elements is defined such that the dynamic range corresponding to the ratio of said value to said internal impedance specific solely to said electrochemical accumulator is ten times lower than the initial dynamic range of said electrochemical accumulator disconnected from said system.

7. Physical measurement system (10) according to any one of the preceding claims, wherein said system comprises at least two separate inductive sensors so as to form, with said assembly of electrical elements external to said electrochemical accumulator, at least two separate resonant electrical circuits capable of resonating within at least two disjoint first predetermined frequency ranges, said extended second predetermined frequency range comprising said at least two first predetermined frequency ranges, the at least two resulting measured resonance frequencies associated with said at least two separate resonant electrical circuits being representative of two separate internal physical quantities of said electrochemical accumulator.

8. Physical measurement system (10) according to any one of the preceding claims, wherein said at least one inductive sensor is an inductor.

9. Physical measurement system (10) according to any one of preceding claims 1 to 7, wherein said at least one inductive sensor is at least one element belonging to the group comprising:
- an inductive strain gauge;
- an inductive diaphragm;
- an inductive sensor with a moving magnetic core.

10. Physical measurement system (10) according to any one of the preceding claims, wherein said assembly of electrical elements external to said electrochemical accumulator is disconnectable/reconnectable to said two separate power terminals.

11. Physical measurement method (40) at the core of an electrochemical accumulator having two separate power terminals, comprising at least the following steps:
- introduction (42) of at least one inductive sensor inside said electrochemical accumulator, said at least one inductive sensor being connected via one of its ends to one of said two separate power terminals, the other end of said inductive sensor being connected, via a direct-current blocking electrical element, to the other of said two separate power terminals;
- connection (46) of an assembly of electrical elements external to said electrochemical accumulator, via each of its two ends to each of said two separate power terminals, so as to form, with said at least one inductive sensor, at least one resonant electrical circuit capable of resonating within at least one first predetermined frequency range;
- excitation (48) of said at least one resonant electrical circuit, via a frequency sweep by controlling the generation of a supply voltage, at said two separate power terminals, over an extended second predetermined frequency range, said extended second predetermined frequency range comprising said at least one first predeterrnined frequency range;
- measurement (50) of at least one resonance frequency resulting from said excitation frequency sweep;
- obtaining (52) a value of at least one internal physical quantity of said electrochemical accumulator from said at least one measured resonance frequency.

12. Physical measurement method (40) according to claim 11, further comprising the introduction (44), inside said electrochemical accumulator, of an assembly of filtering elements limiting the disturbance due to the internal impedance specific solely to said electrochemical accumulator and/or due to the presence of at least one external piece of equipment connected to said electrochemical accumulator.
